(19) Europäisches Patentamt

European Patent Office

Office européen des brevets

(11) EP 0 583 846 B1

(12) EUROPEAN PATENT SPECIFICATION

(45) Date of publication and mention
of the grant of the patent:
**03.02.1999 Bulletin 1999/05**

(51) Int Cl.⁶: **H03J 1/00**, H03J 7/06

(21) Application number: **93202420.1**

(22) Date of filing: **17.08.1993**

(54) **Receiver for receiving high-frequency signals**

Empfänger zum Empfang von HF-Signalen

Récepteur pour signaux à haute frequence

(84) Designated Contracting States:
**DE FR GB IT**

(30) Priority: **18.08.1992 EP 92202520**

(43) Date of publication of application:
**23.02.1994 Bulletin 1994/08**

(73) Proprietor: **Koninklijke Philips Electronics N.V.
5621 BA Eindhoven (NL)**

(72) Inventors:
• **Kianush, Kaveh
 NL-5656 AA Eindhoven (NL)**

• **Egelmeers, Engelbertus Cornelis Joseph
 NL-5656 AA Eindhoven (NL)**
• **Meeuwis, Johannes Cornelis Maria
 NL-5656 AA Eindhoven (NL)**
• **Vereijken, Hubertus Hendrikus Martinus
 NL-5656 AA Eindhoven (NL)**

(74) Representative: **Mak, Theodorus Nicolaas et al
International Octrooibureau B.V.,
Prof. Holstlaan 6
5656 AA Eindhoven (NL)**

(56) References cited:
**WO-A-90/04888        US-A- 4 344 187
US-A- 4 374 437**

## Description

The invention relates to a receiver for receiving high-frequency signals, comprising a receiving section which includes a first frequency loop with a frequency conversion device for frequency conversion of a high-frequency modulated signal, to be applied to the receiving section, into a modulated signal of lower frequency, a detection device for detecting an information signal present in the modulated signal of lower frequency, and a tuning oscillator which is coupled to the frequency conversion device and whose frequency can be adjusted by means of a first tuning control signal which can be supplied by a first tuning control signal generator coupled to the detection device, the receiver comprising a tuning section which includes a second frequency loop with a frequency measuring device for measuring the frequency of the tuning oscillator and a second tuning control signal generator which can be coupled to the frequency measuring device and which serves to generate a second tuning control signal to be applied to the tuning oscillator. A receiver of this kind may be a radio receiver, a television receiver, a video recorder, or a cordless or mobile telephone.

In the US Patent No. 4,344,187 a television receiver is described having a combined AFC and frequency locking loop. The outputs of the loops are combined in a summer and applied to the second loop filter. For weak reception signals, undergoing strong fading, such a locking structure is unsuitable because then easily locking to an unintentional neighbouring channel can occur. Besides, because only the pre-scaler is turned off after the acquisition phase, still considerable power is consumed.

A receiver of this kind in the form of a radio receiver is known as an integrated "AM/FM Radio Receiver Circuit", TEA5592, described in the Philips Data Handbook "Radio, audio and associated systems Bipolar, MOS", Book IC01, 1991, pp. 1047-1060. An application of this IC is shown on page 1057 of said handbook, *i.e.* as an AM/FM radio receiver from aerial signal to low-frequency or audio signal. Tuning of the AM/FM radio receiver is performed manually by means of two ganged capacitors. For FM there is provided a tuning control signal generator FM-AFC, as shown on pages 1049 and 1057, which is coupled to the FM demodulator. The FM-AFC supplies a tuning control signal for the FM tuning oscillator which is coupled to a frequency conversion device, in this case being an FM mixer whereto a high-frequency modulated signal can also be applied. The tuning control signal serves to adjust the oscillator frequency, within a given range, so that fine tuning is achieved after manual tuning which could lead to imperfect tuning to a radio station. Therefore, there is provided a first frequency loop which serves for fine tuning to a radio station to be listened to. The AFC ("Automatic Frequency Control"), ensuring that, despite drift phenomena due to temperature effects, voltage variations and the like, the frequency of the so-called oscillator retains, a value enabling optimum operation of further signal processing means, such as an intermediate frequency stage at a fixed frequency in a superheterodyne receiver, utilizes the so-called FM discriminator characteristic or S-curve. Any variation of the central frequency of the FM discriminator gives rise to DC voltage variations at the output of the discriminator with a polarity which is determined by the direction of the frequency deviation. This DC component is separated from the desired discriminator output signal by means of a low-pass filter, after which it is applied to the local oscillator so that the frequency of the local oscillator is varied in a direction tending to correct the error in the mean intermediate frequency. Tuning errors due to *inter alia* drift phenomena can thus be eliminated to a high degree and accurate tuning is achieved, any selective intermediate frequency amplifiers present in the radio then operating optimally in respect of signal processing. It is a drawback of the known AFC that hysteresis occurs in the tuning, *i.e.* notably in the case of a busy frequency band it is difficult to tune to a desired station because, depending on the search direction in the frequency band, the AFC often acts on a station in the immediate vicinity of the desired station. A further drawback consists in that in the case of fading, *i.e.* a temporary strong reduction of the signal received, notably of importance for portable radio receivers such as portable broadcast receivers and radio receivers in cordless telephones or car telephones, so-called "pulling" to a neighbouring station or radio channel can occur under the influence of the AFC.

From United States Patent Specification No. 4,344,187 there is also known an electronically tunable radio receiver in which the tuning function is provided by a phase locked loop synthesizer which cooperates with an AFC in an intricate manner, thus precluding suitable compromise between the respective loop parameters. The AFC is switched on only when a signal of adequate strength is received; this is detected *via* a muting control function. Using the PLL tuning, radio stations in a frequency band are step-wise searched, the frequency steps being adjusted by means of a programmable divider in the PLL. Even though not shown, control signals for tuning in such electronically tunable radio receivers are usually supplied by a microprocessor. The operation of such PLL tuning is as follows. The phase of the signal of the voltage-controlled tuning oscillator, divided by a dividend, is compared with the phase of a reference clock signal which is generated by a crystal oscillator. The error signal of the phase comparator, being a series of narrow pulses, is integrated in a loop filter which supplies a control voltage for the local oscillator. A different tuning frequency can be chosen by adjustment of a different dividend. A drawback which is of importance notably in portable receivers consists in that the programmable divider has a comparatively high power consumption, *inter alia* because of the feedbacks in the divider which are required for implementing arbitrary dividends. Moreover, the PLL should be carefully designed in respect of noise behaviour in order to ensure that the local oscillator signal-to-noise ratio is not restricted by the tuning system. Furthermore, due to the skipping of narrow pulses in the case of small phase errors, the charge pump in the loop has a dead zone, so that the output signal of the local oscillator exhibits drift phenomena. The PLL residual errors due to this dead zone have a comparatively large bandwidth, so that the time constant of the filter should be comparatively large so as to filter out resultant interference signals, thus leading to a slower tuning system. Therefore, a compromise must be found between interference and speed. Integration of the tuning system with the receiving section in one integrated circuit also poses major problems because of the interference between the tuning system and a receiving section. Because of the step-wise tuning, the tuning quality obtained is inferior to that obtained in radio receivers with manual tuning and AFC, like said TEA5592. Furthermore, PLL tuning is comparatively slow; this is a drawback notably for application in RDS car radios and in cordless telephones or mobile radios. Moreover, PPL implementations in integrated form still require a comparatively large number of external components.

It is an object of the invention to provide a receiver of the kind set forth which comprises digital tuning means and in which the advantages of a manually tunable analog receiver are combined with the possibilities offered by known electronically tunable receivers, without incurring the drawbacks of both types of receivers, *i.e.* to provide fast and accurate tuning which is also comparatively simple and inexpensive.

A receiver in accordance with the invention is characterized in that the receiver comprises a control device with which the first frequency loop can be closed at least in dependence on a first control signal to be supplied by the receiving section, in a preset mode, in which the frequency measuring device can be preset to a desired channel, the frequency measuring device being coupled to the second tuning control signal generator, that the second frequency loop can be closed by the control device on the basis of a second control signal to be applied to the control device by the frequency measuring device that for coarse tuning the second tuning control signal is substantially active outside a frequency window around the desired channel in a frequency band, that for fine tuning the first tuning control signal is substantially active at least within the frequency window, and that the control device controls a change-over from coarse tuning to fine tuning on the basis of the first and the second control signal. By using the second, digital frequency loop and suitably chosen control signals, a fast tuning system is obtained which has the accuracy of manual tuning with AFC. Furthermore, the tuning system can operate in different modes by simple adaptation, for example manual tuning, preset, or automatic search, in combination with automatic storage of frequencies of stations found (autostore) or not. Fine tuning is in principle provided by the first frequency loop, coarse tuning being provided by the second frequency loop, at least in the preset mode, the control device providing the necessary interaction between the two loops. In comparison with a programmable divider in a PLL, the frequency measuring device can be simply integrated and also has a substantially lower power consumption. The amplitude of the first tuning control signal, the AFC signal, varies linearly as a function of the frequency. Outside the frequency window, the second tuning control signal preferably has a constant, positive and negative amplitude, respectively, and has a value zero within the frequency window.

The tuning system in accordance with the invention is based on the behaviour of an operator of a manually tuned analog receiver. The tuning system first adjusts the oscillator frequency coarsely to the desired channel and subsequently achieves the best reception by fine tuning, the oscillator frequency preferably being varied at a speed which is in conformity with the frequency distance yet to be bridged until the desired station is reached.

It is also to be noted that a combined AFC with PLL is known from United States Patent Specification No. 4,955,075, but, apart from the fact that it concerns a PLL, therein switching over from AFC to PLL and *vice versa* takes place on the basis of a control signal obtained from signal strength measurements of the high-frequency modulated signal instead of on the basis of internal operation.

A further embodiment of a receiver in accordance with the invention, intended to increase the tuning speed of the coarse tuning, is characterized in that for coarse tuning further frequency windows are provided around the desired channel, the first tuning control signal being substantially active at least within the inner frequency window, the second tuning control signal being more active during coarse tuning as the frequency of the tuning oscillator is in tuning windows situated further from the desired frequency. It is thus achieved that coarse tuning is faster as the frequency of the tuning oscillator is further from the desired frequency.

A further embodiment of a receiver in accordance with the invention is characterized in that relative to the inner frequency window the further frequency windows constitute a geometrical distribution over the frequency band, the second tuning control signal being a current whose ratio of values over the frequency windows is the same as that of the weighting factors in respect of the geometrical distribution. Maintaining the stability of the tuning system, optimum coarse tuning is thus obtained in respect of speed. When two frequency windows are used, a very substantial increase of the speed of coarse tuning is achieved already in comparison with the use of one frequency window, the gain in speed being marginal as from the use of three frequency windows. This multi-frequency concept again simulates a manual tuning procedure, *i.e.* when the desired channel is still situated far from the current channel, the user will first quickly turn the tuning nob and subsequently ever slower as the frequency distance from the desired channel becomes smaller. In other words, the tuning system operates in conformity with human perception.

An embodiment of a receiver in accordance with the invention is characterized in that frequency measuring periods of the frequency measuring device for measuring the frequency of the tuning oscillator are adapted in proportion to the frequency windows. The speed of the tuning system is thus further increased. This adaptation is based on the idea that tuning time is unnecessarily wasted by performing the measurement constantly with the measuring time of the inner frequency window. Calculations demonstrate that for a ratio of receiving bandwidth to single-sided first frequency window amounting to 1000 and using three frequency windows, the gain in speed in comparison with the use of one frequency window amounts to a factor 33 in the case of geometrical frequency windows, whereas the gain in speed amounts to a factor 200 when the frequency measuring times are further adapted.

A further embodiment of a receiver in accordance with the invention is characterized in that the power to the tuning section is interrupted when the first and second control signals inform the control device that the frequency of the tuning oscillator is situated within the frequency window, or within the inner frequency window in the event of a plurality of windows, as well as within the capture range of the first tuning control signal generator. Because of the fact that the remaining current-carrying control circuits, which may be constructed as low-power circuits, carry comparatively little current with respect to the receiving section, a tuning system is thus obtained which requires substantially the same amount of energy as an analog manual tuning system with AFC in the tuned condition. Furthermore, interference no longer exists between the tuning section and the receiving section.

A further embodiment of a receiver in accordance with the invention is characterized in that before the power to the tuning section is interrupted, the last channel frequency measured is stored in a last-channel memory. Should undesirable effects such as fading or pulling occur upon deactivation of the tuning section and should the current to the tuning section be restored again because of disappearance of the first control signal, the tuning section can directly respond to these undesirable effects, utilizing the last channel frequency measured which is stored in the last-channel memory, so that very firm control is obtained.

A further embodiment of a receiver in accordance with the invention is characterized in that the first tuning control signal generator is decoupled from the tuning oscillator when the frequency of the tuning oscillator is outside the frequency window, or, outside the inner frequency window in the event of a plurality of windows, the second frequency loop being subsequently activated. "Pulling" in the event of *inter alia* fading is thus prevented.

An embodiment of a receiver in accordance with the invention is characterized in that the receiver comprises a control device with which the first frequency loop can be closed at least in dependence on a first control signal to be supplied by the receiving section, in a search mode, in which an arbitrary channel is searched within a frequency band, the power to the frequency measuring device being interrupted and the frequency measuring device being decoupled from the second tuning control signal generator, that the second tuning control signal generator directly controls the tuning oscillator so as to scan the frequency band, that the control device interrupts the search, on the basis of a control signal to be supplied by the first tuning control signal generator, when a channel containing a signal is tuned to, and that subsequently the frequency measuring device is activated so as to measure the frequency of the tuning oscillator and to store the measured frequency in a last-channel memory, after which the control device interrupts the power to the tuning section. Because the frequency measuring device does not receive power and is decoupled during the search mode, no interference occurs with the receiving section, so that it is impossible to stop at incorrect positions within the frequency band. When a station has been found, after frequency measurement and storage the tuning system enters the standby mode, so that the receiver as a whole has an as low as possible power consumption. Because of the storage of the frequency of the tuned channel, quick response to fading and pulling is again possible, so that a firm tuning system is realised also in the search mode. A microprocessor, if any, in the receiver, therefore, in principle has no other tasks than to scan a control panel and to control a display panel such as an LCD screen. The automatic search is fast because the smaller amount of tuning software and hence the substantially shorter communication procedure, like in known electronic tuning systems between the microprocessor and the synthesizer.

The invention will be described in detail hereinafter with reference to a drawing; therein

Fig. 1 shows a block diagram of a receiver in accordance with the invention,
Fig. 2 shows control currents in a receiver in accordance with the invention as a function of the frequency,
Fig. 3 shows a state diagram for control currents in a receiver in accordance with the invention,
Fig. 4 shows a measuring cycle of a frequency measuring device in a receiver in accordance with the invention,
Fig. 5 shows a geometrical distribution of frequency windows over a frequency band,
Fig. 6 shows an embodiment of a tuning section in a receiver in accordance with the invention, and Fig. 7 shows a charge pump circuit for use in the tuning section.

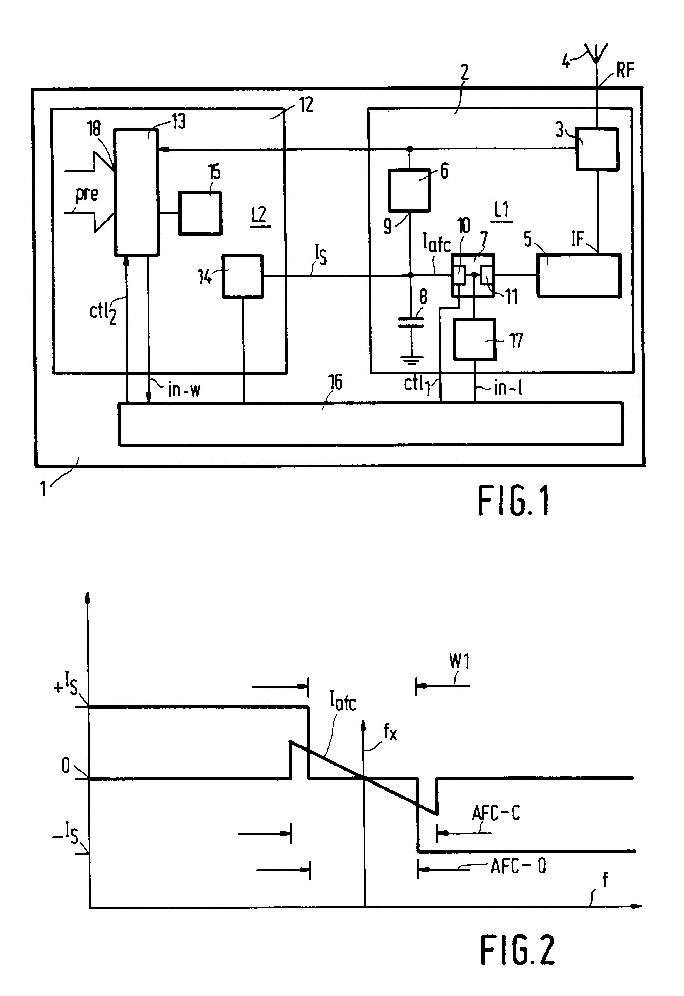

Fig. 1 shows a block diagram of a receiver 1 in accordance with the invention. The receiver 1 comprises a receiving section 2 which includes a first frequency loop L1 with a frequency conversion device 3 for frequency conversion of a high-frequency modulated signal RF, to be applied to the receiving section 2 *via* an aerial 4, into a modulated signal IF of lower frequency. The frequency loop L1 also comprises a detection device 5 for detection of an information signal present in the modulated signal of lower frequency IF, for example a radio or television broadcast signal or a telephone signal, and a tuning oscillator 6 which is coupled to the frequency conversion device 3 and whose frequency can be adjusted by means of a first tuning control signal $I_{afc}$ to be supplied by a first tuning control signal generator 7 coupled to the detection device 5. The tuning control signal generator may comprise a controlled current source 10 which applies a tuning control signal $I_{afc}$ in the form of a current to a loop filter 8, preferably an integrator, which is formed by a capacitor for integration of the current $I_{afc}$, so that there is formed a control voltage $\int I_{afc}.dt$ for supply to a control input 9 for controlling the tuning oscillator 6, being a VCO (Voltage Controlled Oscillator) in the present embodiment. The tuning control signal generator 7 also comprises a low-pass filter 11 which filters an output signal of the detection device 5, for example an FM discriminator, and outputs it as a control signal for the controlled current source 10. In a superheterodyne receiver the frequency conversion device 3 may be a customary mixing stage for mixing the high-frequency modulated signal RF so as to form the modulated signal of lower frequency IF, being an intermediate frequency, for example 10.7 MHz in the event of broadcast FM. Conventional selective intermediate frequency amplifiers comprising fixed filter sections, then present in the receiving section 2, are assumed to be included in the detection device 5 for the sake of simplicity. Other customary structures are also feasible for the receiving section 2, for as long as a suitable control signal can be applied to the tuning oscillator 6 for frequency tuning thereof in the first frequency loop L1. The invention is not restricted to FM modulated signals, other modulation types such as AM and PM also being possible. In addition to a superheterodyne structure, for example a receiving section 2 based on a so-called direct-conversion structure which is very well suitable for integration is also feasible. In order to minimize tuning errors in the receiving section 2 *per se*, caused by DC offsets and leakage currents in the AFC loop, the current source 10 should have a very high output impedance; this can be achieved, for example by choosing a so-called Wilson current mirror configuration in which an input current is applied to a conventional current mirror configuration but an output current is supplied *via* an output transistor in cascode connection with a mirror transistor. The input current of the current source 10, supplied *via* the low-pass filter 11, can then be delivered by a voltage/current converter (not shown) coupled to symmetrical outputs of the detector 5. The receiver also comprises a tuning section 12 which includes a second frequency loop L2 with a frequency measuring device 13 for measuring the frequency of the tuning oscillator 6, and a second tuning control signal generator 14 which can be coupled to the frequency measuring device 13 and which serves to generate a second tuning control signal $I_s$ to be applied to the tuning oscillator 6. A measured frequency of the tuning oscillator 6 can be stored in a last-channel memory 15. The receiver also comprises a control device 16 for controlling the receiving section 2 and the tuning section 12. In the preset mode (preset tuning) of the receiver 1, the control device 16 will, in a manner in accordance with the invention yet to be described, control and/or open or close the first and/or the second frequency loop, *i.e.* in this mode both frequency loops L1 and L2 are active. During operation of the receiver 1 in the search mode (autosearch tuning), in given circumstances only the first frequency loop L1 is active, the frequency measuring device 13 being used to measure the frequency of the relevant station after a station has been found. The control device 16 can close the frequency loop L1 at least in dependence on a first control signal in-1 (in-lock signal) to be supplied by the receiving section 2. Depending on the mode of operation of the receiver, the control device 16 controls the first and/or the second frequency loop L1 and L2 also on the basis of a second control signal in-w (in-window signal) to be applied to the control device 16 by the frequency measuring device 13. The in-lock signal in-1 is formed, by an in-lock detection device 17, from the AFC signal from the detection device 5 which is filtered by the low-pass filter 11. The in-lock detection device 17, being described in detail in the simultaneously filed European Patent Application No. ...., supplies a reliable in-lock signal, indicating that the first frequency loop has been adjusted with a given accuracy, by very accurate analysis of the so-called S-curve. The control device 16 also supplies the current source 10 and the frequency measuring device 13 with control signals ct11 and ctl2 for respective control and on/off switching. The control device can also autonomously control the second tuning control signal generator 14, which may be a controllable charge pump having several control inputs, in the autosearch mode. The frequency measuring device 13 may be a programmable counter having a preset input 18 for receiving a digital preset signal pre which can be supplied by a microprocessor (not shown) or also, in a simple and inexpensive embodiment of the receiver 1 in accordance with the invention, by a hardware preset device consisting of a number of flipflop registers. Such a simple embodiment can be implemented in comparatively inexpensive portable broadcast receivers. The presets can be adjusted during the auto-search mode or also *via* a frequency which can be entered *via* a keyboard and which is loaded into the preset registers after having been digitized.

Fig. 2 shows the control currents $I_{afc}$ and $I_s$ in a receiver 1 in accordance with the invention as a function of the frequency f. The control current $I_s$ varies non-linearly as a function of the frequency f relative to the desired frequency $f_x$, and has a positive value $+I_s$ or a negative value $-I_s$ outside a frequency window or tuning window for coarse tuning W1 which should be narrower than half the channel spacing. Also shown is an AFC capture range AFC-C within which $I_{afc}$ varies linearly and beyond which $I_{afc}$ has a value zero, and also an AFC operating range AFC-O within the AFC capture range AFC-C. The actual polarity depends on signal inversions, if any, present in the loops L1 and L2, *i.e.* taking into account the correct control effect, polarities may be reversed. Referring to Fig. 1, in the preset mode the loops L1 and L2 for coarse tuning and fine tuning, respectively, cooperate as follows. The receiving section 2 compares and correlates the output signal of the tuning oscillator 6 with the high-frequency modulated signal RF and generates the control current $I_{afc}$ on the basis thereof. If the error is comparatively small, the in-lock signal in-1 is generated in the in-lock detection device 17. The tuning section 12 also executes a frequency comparison, be it in respect of the desired preset signal pre. The tuning section 12 acknowledges that coarse tuning has been achieved by way of the in-window signal in-w which indicates that the oscillator frequency of the tuning oscillator 6 is within the frequency window W1. In the preset mode it is desirable to have an in-lock window which is wider than the tuning window W1, whereas in the autosearch mode a narrow in-lock window is desirable to avoid the missing of channels. When a different station is desired in the preset mode, the tuning section 12 applies a constant current in order to adjust the tuning oscillator coarsely to the correct frequency, fine tuning being subsequently provided by the AFC loop. The operating ranges of the loops L1 and L2 in principle exclude one another, as shown in Fig. 2, the in-lock and in-window signals being used to coordinate the transition from one loop to the other loop and *vice versa*. Correct reception of the desired signal is achieved when the tuning section 12 is "in-window" and the receiving section is "in-lock". The tuning process has then been completed and the power to the tuning section can be interrupted, resulting in a substantial saving of power. The latter is important notably for portable receivers. Because annoying interference between the receiving section 2 and the tuning section 12 is no longer experienced, the receiving section 2 can be more readily integrated with the tuning section 12 on a single IC, together with the control section 16, and the number of external components can also be reduced. When the receiver 1 is used as a portable receiver, the field strength of the high-frequency signal RF received will continuously vary in practical situations, its strength being dependent notably on the relevant frequency band. This may give rise to undesirable effects, such as fading and pulling to an adjacent channel. In order to solve this problem, the frequency of the signal received is written into the last-channel memory 15 after correct tuning and before the power to the tuning section 12 is interrupted. Such a memory 15 may be SRAM having a very low power consumption. In the event of fading or pulling, the in-lock signal temporarily disappears. The control device immediately responds thereto by restoring the power to the tuning section 12. The tuning section 12 then measures the frequency of the tuning oscillator 6 again, utilizing the information stored in the last-channel memory 15, and makes the necessary corrections in the described manner.

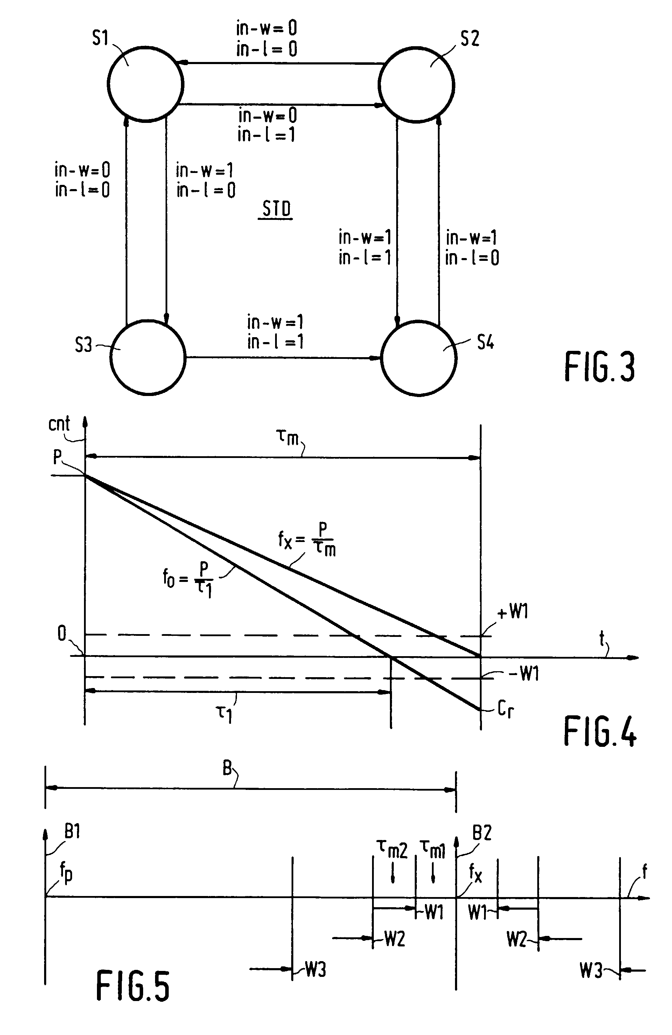

Fig. 3 shows a state diagram STD for control currents $I_{afc}$ and $I_s$ in a receiver 1 in accordance with the invention for operation of the receiver in the preset mode. A description on the basis of the state diagram STD substantially simplifies the design of the two-loop structure in respect of stability and tuning speed. The Figure shows a pre-acquisition state S1, in which the control current source $I_s$ supplies current and $I_{afc}$ does not supply current, an acquisition or fading state S2 in which the current $I_s$ is not "in-window" W1 and the current $I_{afc}$ is "in-window" W1, a no-signal state S3 in which the current source $I_s$ does not supply a current and the current source $I_{afc}$ supplies a current, and the post-acquisition state or state of desired tuning S4 in which the current source $I_s$ does not supply a current and the current source $I_{afc}$ supplies a current. Other changes of state can be represented in a similar manner. Changes of state are denoted by arrows, the control signals in-w and in-1, and 0 and 1, respectively, adjacent each arrow indicating whether the desired frequency is "in-lock" and/or "in-window".

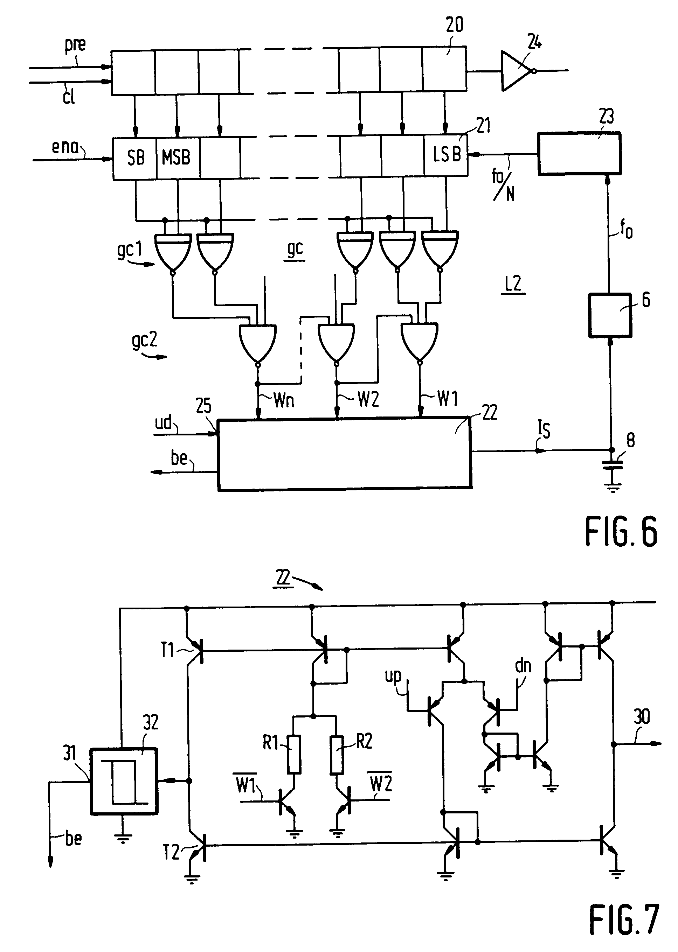

Fig. 4 shows a measuring cycle of a frequency measuring device 13 in a receiver 1 in accordance with the invention, in which initial value cnt of the frequency measuring device 13, for example being a programmable counter, is plotted as a function of time t. The count represents a frequency and P is a binary representation of the preset value of the preset signal pre. The counter 13 measures the frequency $f_0$ of the tuning oscillator 6 relative to the desired frequency $f_x$. First the preset signal pre is loaded into the counter 13 and subsequently the counter counts down for a predetermined reference period $\tau_m$ (down counting). At the end of the measuring period $\tau_m$, the counter residue Cr is compared with the defined tuning frequency window +W1 to -W1. Depending on the sign of the residue Cr, the current source 14 generates a correction current $+I_s$ or $-I_s$, which current is integrated by the loop filter 8 so as to form a voltage whereby the tuning oscillator 6 is controlled. The gain of the tuning oscillator then amounts to $K_0$. A practical embodiment will be described with reference to the Figs. 6 and 7. Because of the non-linear nature of the charge pump 14, the frequency of the tuning oscillator will continuously vary during the tuning cycle. The frequency counter 13, however, should continuously measure the frequency of the tuning oscillator 6 in order to decide whether or not the frequency is "in-window". If the time in which the frequency sweep of the tuning oscillator 6 across one tuning window exceeds the measuring period $\tau_m$, the tuning system becomes unstable. For a stable system, the measuring time delay $\tau_m$, should be smaller than or equal to the loop delay $\tau_1$. It can be deduced that for a stable system:

$$\tau_m \leq \frac{2.W1.C}{K_0.I_s}$$

where C is the capacitance of the loop filter 8. If the frequency $f_0$ of the tuning oscillator 6 equals the desired frequency $f_x$, the counter 13 will count down exactly to 0 during the measuring period $\tau_m$. The gradient of the down-count is thus a measure for the actual frequency $f_x$. The counter 13 is controlled by a clock signal. The estimation of the frequency of the tuning oscillator 6 is an integral over the clock pulses, containing this gradient, over the measuring period $\tau_m$, or:

In reality, instead of a linear relationship a discrete relationship exists, but if the word length of the counter 13 is sufficiently long, the linear approximation is quite

$$\int_0^{\tau_m} (P/\tau_m).dt$$

satisfactory. When the tuning oscillator 6 is adjusted exactly correctly, the value of the integral will be equal to P at the end of the measuring period $\tau_m$, but in the event of incorrect adjustment relative to the desired frequency $f_x$, the estimate will be $P.\tau_m/\tau_1$, for example when the counter reaches a zero position after a period $\tau_1$. The frequency $f_0$ of the tuning oscillator 6 is "in-window" if the absolute value of $(P.((\tau_m/\tau_m)-1)$ is smaller than or equal to W1. In a dynamic situation, in which the tuning frequency varies continuously, the situation is more complex but it can be simply demonstrated that in the event of a linear frequency sweep of the frequency of the tuning oscillator 6 during the measuring period $\tau_m$, the same stability criterion holds as in a static situation as described. The stability criterion of the tuning loop L2 limits the maximum tuning speed at which tuning from one preset value to the other preset value can take place. In the case of a tuning system comprising one tuning window W1, in given circumstances the tuning speed may become too slow, for example, in the event of a frequency band comprising many channels, but the tuning speed can be very substantially increased by using more than one frequency window.

Fig. 5 shows a geometrical distribution of frequency windows over a frequency band, as a function of the frequency f, where B is a receiving bandwidth with band edges B1 and B2, $f_x$ is a desired frequency, and W1, W2 and W3 are frequency windows in a tuning system in accordance with the invention which comprises more than one frequency window. A maximum frequency distance to be bridged is assumed, *i.e.* the current frequency $f_p$ is at one band edge B1 and the desired frequency $f_x$ is at the other band edge B2. It can be simply demonstrated that the maximum permissible tuning current is linearly proportional to the tuning window in view of stability requirements. Therefore, when a second, wider frequency window is used, a larger tuning current can be permitted for a part of the frequency distance to be bridged, stability still being maintained. An optimum situation of the second frequency window is obtained if $B.W1 = W2.W2$, *i.e.* a situation in which equal tuning times are obtained for tuning from B1 to W2 and for tuning from W2 to W1. When the frequency window is further increased, similar considerations apply, *i.e.* a mutually optimum situation of frequency windows is achieved in respect of tuning speed if the frequency windows are geometrically distributed over the receiving band, *i.e.* if:

$$W_n = W_1 \cdot (\frac{B}{W_1})^{\frac{n-1}{n}}$$

where n is an integer positive number greater than one. For an optimum tuning system for the tuning currents in the respective frequency windows the same weighting factors hold as for the situation of the tuning windows. In the embodiment shown, comprising three frequency windows W1, W2 and W3 with a B/W1 ratio of 1000, a gain in the speed of tuning by a factor 33 is achieved relative to a tuning system comprising one frequency window in the event of an optimum choice of frequency windows and tuning currents. It has been assumed that the window detection mechanism is independent of the measuring time required by the frequency measuring device or the counter 13 for measurement of the frequency of the tuning oscillator 6. For a stable tuning system, the tuning current within a given frequency window may not be so large that the counter 13 no longer has a measuring point within the relevant frequency window, *i.e.* it would be a waste of measuring time if the counter were to have an inadequate resolution within a frequency window, because the effective width of the frequency window would then be reduced and hence also the total system response. An excessively high counter resolution, however, would result in an excessive measuring time. It can be simply demonstrated that the optimum resolution of the counter 13 is $W_1/2$. Even though the tuning currents to be adjusted on the basis thereof are lower than the maximum currents permissible in view of stability, the tuning speed does not decrease in proportion but to a lesser extent, depending on the number of frequency windows used and on the receiving bandwidth. A further acceleration of the tuning process is achieved by abstaining from keeping the measuring period of the counter 13 in the windows constant, but varying it across the windows in a tuning system in accordance with the invention which comprises several tuning windows. For a tuning system comprising two windows, the measuring period is chosen to be $\tau_{m1} = 1/W1$ for the inner window and $\tau_{m2}$ for the outer window, the choice for a larger number of windows being similar. It can be simply demonstrated that, utilizing also a variable measuring period, the tuning time of the tuning system comprising three windows amounts to only 1/200 of the tuning time of a tuning system comprising one window.

The receiver 1 in accordance with the invention can operate not only in the preset mode, but also in the so-called autosearch mode. During a first phase of the tuning process in the autosearch mode, the frequency counter 13 does not form part of the loop L2, the tuning current being adjusted directly by the control device 16 which applies a frequency sweep to the tuning oscillator 6. If a station is found during the frequency sweep in the next channel, the in-lock detection device 17 generates an in-lock signal in-l. The control device 16 confirms the in-lock signal in-1 by immediately interrupting the tuning current, the loop L1 ensuring that the relevant station is tuned to as well as possible. Subsequently, the frequency measuring device 13 measures the frequency of the tuning oscillator 6 and writes the measured frequency into the last-channel memory 15. The tuning process is then completed and the control device 16 interrupts the power to the tuning section 12 and monitors the loops L1 and L2 in the manner described with reference to the preset mode. In the (auto)search mode a number of stations can also be acquired which are stored as preset stations. The analog autosearch mode is much faster than a search process in a customary digital receiver comprising a microprocessor, because of the absence of the long communication procedure between the microprocessor and the synthesizer which is required in the latter case. In the autosearch mode in accordance with the invention, the speed of the tuning process is determined mainly by the in-lock delay which is determined by audiofiltering in the receiving section 2 which is situated ahead of the in-lock detection device 17. In FM receivers such filtering is required for audio signal suppression and in AM receivers for amplitude stabilization. The in-lock delay causes overshoot in the response of the tuning system, the overshoot being dependent on the in-lock delay and the frequency sweep speed in a manner substantially similar to the braking distance of a vehicle. The overshoot may not be greater than the width of the tuning window W1, because the tuning current is otherwise interrupted too late so that the station is missed.

The tuning section 12 can be fully integrated with the receiving section 2, together with the control device 16, the loop filter 8 for the loop L2, also used as the AFC filter for the loop L1, being reduced to simply a capacitor.

Fig. 6 shows an embodiment of a tuning section 12 in a receiver 1 in accordance with the invention. The tuning section 12 comprises an input shift register 20 for receiving the preset signal pre, the control device 16 applying a clock signal c1 thereto for clocking the signal pre. The input shift register 20 is coupled at its output sides to inputs of a asynchronous counter 21 having a low power consumption. The preset signal pre can be presented in binary form, in which case the asynchronous counter 21 is a so-called binary ripple down-counter. Furthermore, in such a counter the bits require less power as they are more significant. The counter 21 is programmable, on the one hand by the preset facility and on the other hand by a enable input ena. Counter outputs of the counter 21 are applied, *via* a gate circuit gc, to a charge pump circuit 22. The gate circuit gc serves to supply frequency window signals W1, W2, ... Wn, n being an integer positive number. The charge pump circuit supplies the control current $I_s$ of the second frequency loop L2. Also shown is the tuning oscillator 6, an output signal of which, having the frequency $f_0$, can be applied, to the programmable counter 21, if desired *via* a pre-scaler 23 having a scale factor N. For the operation of the counter 21, reference is made to Fig. 4. If the frequency of the tuning oscillator 6 is too low, the counter residue Cr is positive and if the frequency of the tuning oscillator 6 is exactly equal to the desired frequency $f_x$, the counter residue Cr is zero. The window detection is simple in these two cases. The tuning oscillator 6 is "in-window" only if all counter bits lower than the window bit W1, W2, ..., Wn are zero at the end of the measuring period $\tau_m$. However, if the frequency of the tuning oscillator 6 is too high, the counter residue Cr is negative. Window detection can then be performed in the above manner, after the counter outputs have been inverted. The clock frequency of the counter 21, controlling the least-significant bit LSB of the counter 21, is either a signal of frequency $f_0$ of the tuning oscillator 6 or a version $f_0/N$ thereof which has been divided by the pre-scaler 23. A sign bit SB, preceding the most-significant bit MSB, of the counter 21 detects whether the counter 21 crosses zero or not. The counting period $\tau_m$ of the counter 21 is determined by the enable signal ena supplied by the control device 16. Inversion of the counter bits, in dependence on the sign bit SB, is performed by a first row of gates gc1 of the gate circuit gc, and window detection is performed by a second row of gates gc2. In the autosearch mode, in which the frequency loop L2 is not closed and no window detection takes place, the gate circuit gc is decoupled from the charge pump circuit 22 and the counter 21 serves to measure the frequency of the tuning oscillator 6. After measurement of the frequency $f_0$ of the tuning oscillator 6, the binary representation thereof is applied, *via* the shift register 20 which then acts as an output shift register and the inverter 24, to the last-channel memory 15. In the event of a change-over to the preset mode, the binary representation provides an "in-window" signal for all frequency windows. The frequency measurement in the autosearch mode is performed as follows, utilizing a one's-complement method. First the counter is filled entirely with logic values "1" and subsequently a count-down cycle is performed. At the end of the count-down cycle, the counter 21 contains the binary representation of the frequency $f_0$ of the tuning oscillator 6 in a one's-complement representation, the sign bit SB being insignificant. The correct frequency is obtained by inversion of the counter outputs, in this case represented as a serial inversion by means of the inverter 24. For storage of the measured frequency in the last-channel memory 15, parallel inversion is to be preferred. In order to avoid a latch-up situation at band edges, the charge pump circuit 22 comprises a band edge detector which applies a band edge signal be to the control device 16. For scanning of the frequency band B in the one or the other direction, the charge pump circuit comprises a control input 25 for supply of an up/down signal ud.

Fig. 7 shows a charge pump circuit 22 for use in the tuning section 12, comprising an output 30 for coupling to the loop filter 8. The charge pump circuit comprises control inputs up and dn for applying a current to the output 30 which has a first and a second current direction, respectively, and window inputs not- (W1) and not- (W2), *i.e.* a charge pump circuit 22 is shown for a two-window tuning system. The charge pump circuit 22 also comprises an output 31 for supplying the band edge signal be. The charge pump circuit 22 does not supply an output signal if both "in-window" signals W1 and W2 have a logic value "1". The resistors R1 and R2 determine the current intensity of the charge pump circuit 22 in the respective frequency windows W1 and W2. In the preset mode, the signals up and dn are actually the sign bit SB and the inverted sign bit, whereas in the autosearch mode the signals up and dn are generated directly by the keyboard (not shown). For band edge detection, the charge pump circuit 22 comprises a trigger device 32 in combination with the transistors T1 and T2, only the detection of the lower band edge B1 being shown. For detection of the upper band edge B2, the charge pump circuit 22 comprises a similar sub-circuit. It concerns a coarse detection of band edges. For finer detection use can be made of a microprocessor (not shown) included in the receiver 1.

## Claims

1. A receiver (1) for receiving high-frequency signals, comprising a receiving section (2) which includes a first frequency loop (L1) with a frequency conversion device (3) for frequency conversion of a high-frequency modulated signal (RF), to be applied to the receiving section (2), into a modulated signal (IF) of lower frequency, a detection device (5) for detecting an information signal present in the modulated signal (IF) of lower frequency, and a tuning oscillator (6) which is coupled to the frequency conversion device (3) and whose frequency can be adjusted by means of a first tuning control signal ($I_{afc}$) which can be supplied by a first tuning control signal generator (7) coupled to the detection device (5), the receiver (1) comprising a tuning section (12) which includes a second frequency loop (L2) with a frequency measuring device (13) for measuring the frequency ($f_0$) of the tuning oscillator (6) and a second tuning control signal generator (14) which can be coupled to the frequency measuring device (13) and which serves to generate a second tuning control signal ($I_s$) to be applied to the tuning oscillator (6), characterized in that the receiver (1) comprises a control device (16) with which the first frequency loop (L1) can be closed at least in dependence on a first control signal (in-1) to be supplied by the receiving section (2), in a preset mode, in which the frequency measuring device (13) can be preset to a desired channel ($f_x$), the frequency measuring device (13) being coupled to the second tuning control signal generator (14), that the second frequency loop (L2) can be closed by the control device (16) on the basis of a second control signal (in-w) to be applied to the control device (16) by the frequency measuring device (13), that for coarse tuning the second tuning control signal ($Is$) is substantially active outside a frequency window (W1) around the desired channel ($f_x$) in a frequency band (B), that for fine tuning the first tuning control signal ($I_{afc}$) is substantially active at least within the frequency window (W1), and that the control device (16) controls a change-over from coarse tuning to fine tuning on the basis of the first (in-1) and the second (in-w) control signal.

2. A receiver (1) as claimed in Claim 1, characterized in that in the preset mode, in which the frequency measuring device (13) can be preset to a desired channel ($f_x$), the frequency measuring device (13) is coupled to the second tuning control signal generator (14), that the second frequency loop (L2) can be closed by the control device (16) on the basis of a second control signal (in-w) to be applied to the control device (16) by the frequency measuring device (13), that for coarse tuning the second tuning control signal ($I_s$) is substantially active outside a frequency window (W1) around the desired channel ($f_x$) in a frequency band (B), that for fine tuning the first tuning control signal ($I_{afc}$) is substantially active at least within the frequency window (W1), and that the control device (16) controls a changeover from coarse tuning to fine tuning on the basis of the first (in-l) and the second (in-w) control signal.

3. A receiver (1) as claimed in Claim 2, characterized in that for coarse tuning further frequency windows (W2, W3) are provided around the desired channel ($f_x$), the first tuning control signal ($I_{afc}$) being substantially active at least within the inner frequency window (W1), the second tuning control signal ($I_s$) being more active during coarse tuning as the frequency of the tuning oscillator (6) is in tuning windows (W3, W2) situated further from the desired frequency ($f_x$).

4. A receiver (1) as claimed in Claim 3, characterized in that relative to the inner frequency window (W1) the further frequency windows (W2, W3) constitute a geometrical distribution over the frequency band (B), the second tuning control signal ($I_s$) being a current whose ratio of values over the frequency windows (W1, W2, W3) is the same as that of the weighting factors in respect of the geometrical distribution.

5. A receiver (1) as claimed in Claim 3 or 4, characterized in that frequency measuring periods ($\tau_{m1}$, $\tau_{m2}$) of the frequency measuring device (13) for measuring the frequency ($f_0$) of the tuning oscillator (6) are adapted in proportion to the frequency windows (W1, W2).

6. A receiver (1) as claimed in Claim 2, 3, 4 or 5, characterized in that the power to the tuning section (12) is interrupted when the first (in-I) and second (in-w) control signals inform the control device (16) that the frequency ($f_0$) of the tuning oscillator (6) is within the frequency window (W1), or within the inner frequency window (W1) in the event of a plurality of windows (W1, W2, W3), as well as within the capture range of the first tuning control signal generator (7).

7. A receiver (1) as claimed in Claim 6, characterized in that before the power to the tuning section (12) is interrupted, the last channel frequency measured ($f_x$) is stored in a last-channel memory (15).

8. A receiver (1) as claimed in any one of the Claims 2 to 7, characterized in that the first tuning control signal generator (7) is decoupled from the tuning oscillator (6) when the frequency ($f_0$) of the tuning oscillator (6) is outside the frequency window (W1), or outside the inner frequency window (W1) in the event of a plurality of windows (W1, W2, W3), the second frequency loop (L2) being subsequently activated.

9. A receiver (1) as claimed in any one of the Claims 2 to 8, characterized in that the frequency window (W1), or the inner frequency window (W1) in the event of a plurality of frequency windows (W1, W2, W3), is narrower than half the channel spacing within the frequency band (B).

10. A receiver (1) for receiving high-frequency signals, comprising a receiving section (2) which includes a first frequency loop (L1) with a frequency conversion device (3) for frequency conversion of a high-frequency modulated signal (RF), to be applied to the receiving section (2), into a modulated signal (IF) of lower frequency, a detection device (5) for detecting an information signal present in the modulated signal (IF) of lower frequency, and a tuning oscillator (6) which is coupled to the frequency conversion device (3) and whose frequency can be adjusted by means of a first tuning control signal ($I_{afc}$) which can be supplied by a first tuning control signal generator (7) coupled to the detection device (5), the receiver (1) comprising a tuning section (12) which includes a second frequency loop (L2) with a frequency measuring device (13) for measuring the frequency ($f_0$) of the tuning oscillator (6) and a second tuning control signal generator (14) which can be coupled to the frequency measuring device (13) and which serves to generate a second tuning control signal ($I_s$) to be applied to the tuning oscillator (6), characterized in that the receiver (1) comprises a control device (16) with which the first frequency loop (L1) can be closed at least in dependence on a first control signal (in-1) to be supplied by the receiving section (2), in a search mode, in which an arbitrary channel ($f_x$) is searched within a frequency band (B), the power to the frequency measuring device (13) being interrupted and the frequency measuring device being decoupled from the second tuning control signal generator (14), that the second tuning control signal generator (14) directly controls the tuning oscillator (6) so as to scan the frequency band (B), that the control device (16) interrupts the search mode, on the basis of a control signal (in-I) to be supplied by the first tuning control signal generator (7), when a channel containing a signal is tuned to, and that subsequently the frequency measuring device (13) is activated so as to measure the frequency ($f_0$) of the tuning oscillator (6) and to store the measured frequency ($f_x$) in a last-channel memory (15), after which the control device (16) interrupts the power to the tuning section.

**Patentansprüche**

1. Empfänger (1) zum Empfang von HF-Signalen mit einem Empfängerteil (2) mit einer ersten Frequenzschleife (L1) mit einem Frequenzwandler (3) zur Frequenzumwandlung eines dem Empfängerteil (2) zuführbaren HF-modulierten Signals (RF) zu einem modulierten Signal (IF) mit einer niedrigeren Frequenz, mit einer Detektionsanordnung (5) zur Detektion eines in dem modulierten Signal (IF) mit der niedrigeren Frequenz vorhandenen Informationssignals, und mit einem mit dem Frequenzwandler (3) gekoppelten Abstimmoszillator (6), der in der Frequenz mittels eines ersten Abstimmregelsignals ($I_{afc}$) einstellbar ist, das von einer mit der Detektionsanordnung (5) gekoppelten ersten Abstimmregelsignalerzeugungsanordnung (7) lieferbar ist, wobei der Empfänger (1) einen Abstimmteil (12) aufweist, der eine zweite Frequenzschleife (L2) umfaßt mit einer Frequenzmeßanordnung (13) zum Messen der Frequenz ($f_0$) des Abstimmoszillators (6) und einen zweiten Abstimmregelsignalgenerator (14), der mit der Frequenzmeßanordnung (13) gekoppelt werden kann und der zum Erzeugen eines dem Abstimmoszillator (6) zuzuführenden zweiten Abstimmregelsignals ($I_s$) dient, dadurch gekennzeichnet, daß der Empfänger (1) eine Steueranordnung (16) aufweist, mit der wenigstens in Abhängigkeit eines von dem Empfängerteil (2) lieferbaren Steuersignals (in-1) die erste Frequenzschleife (L1) schließbar ist, in einer Preset-Betriebsart, in der die Frequenzmeßanordnung (13) auf einen gewünschten ($f_x$) Kanal voreingestellt werden kann, wobei die Frequenzmeßanordnung (13) mit dem zweiten Abstimmregelsignalgenerator (4) gekoppelt ist, daß die zweite Frequenzschleife (L2) durch die Regelschaltung (16) auf Basis eines zweiten der Regelschaltung (16) durch die Frequenzmeßanordnung (13) zuzuführenden Steuersignals (in-w) geschlossen werden kann, daß zur Grobabstimmung das zweite Abstimmregelsignal ($I_s$) im Wesentlichen außerhalb eines Frequenzfensters (W1) um den gewünschten Kanal ($f_x$) in einem Frequenzband (B) herum aktiv ist, daß zur Feinabstimmung das erste Abstimmregelsignal ($I_{afc}$) im Wesentlichen innerhalb des Frequenzfensters (W1) aktiv ist, und daß die Regelschaltung (16) eine Umschaltung von Grobabstimmung zu Feinabstimmung auf Basis des ersten (in-1) und zweiten Steuersignals (in-w) steuert.

2. Empfänger (1) nach Anspruch 1, dadurch gekennzeichnet, daß in der Preset-Mode, worin die Frequenzmeßanordnung (13) auf einen gewünschten Kanal ($f_x$ voreingestellt werden kann, wobei die Frequenzmeßanordnung (13) mit dem zweiten Abstimmsteuersignalgenerator (14) gekoppelt ist, daß die zweite Frequenzschleife (L2) durch die Steueranordnung (16) geschlossen werden kann auf Basis eines von der Frequenzmeßanordnung (13) der Steueranordnung (16) lieferbaren zweiten Steuersignals (in-W), daß zur Grob abstimmung das zweite Abstimmregelsignal ($I_s$) außerhalb eines Frequenzfensters (W1) um den gewünschten Kanal ($f_x$) in einem Frequenzband (B) herum wesentlich aktiv ist, daß zur Feinabstimmung das erste Abstimmregelsignal ($I_{afc}$) wenigstens innerhalb des Frequenzfensters (W1) wesentlich aktiv ist und daß die Steueranordnung (16) den Übergang von Grobabstimmung zur Feinabstimmung auf Grund des ersten (in-1) und zweiten (in-w) Steuersignals steuert.

3. Empfänger (1) nach Anspruch 2, dadurch gekennzeichnet, daß es zur Grobabstimmung weitere Frequenz fenster (W2, W3) gibt um den gewünschten Kanal ($f_x$) herum, wobei das erste Abstimmregelsignal ($I_{afc}$) wenigstens innerhalb des inneren Fensters (W1) wesentlich aktiv ist und das zweite Abstimmregelsignal ($I_s$) während der Grobabstimmung aktiver ist je nachdem die Frequenz des Abstimmoszillators (6) sich in weiter von der gewünschten Frequenz ($f_x$) liegenden Abstimmfenstern (W3, W2, W1) befindet.

4. Empfänger (1) nach Anspruch 3, dadurch gekennzeichnet, daß die weiteren Frequenzfenster (W2, W3) gegenüber dem innern Frequenzfenster (W1) eine geometrische Verteilung bilden über das Frequenzband (B) und das zweite Abstimmregelsignal ($I_s$) ein Strom ist, dessen Stärke sich über die Frequenzfenster (W1, W2, W3) verhält gemäß denselbcn Gewichtungsfaktoren wie in Bezug auf die geometrische Verteilung.

5. Empfänger (1) nach Anspruch 3 oder 4, dadurch gekennzeichnet, daß die Frequenzmeßzeiten ($\tau_{m1}$, $\tau_{m2}$) der Frequenzmeßanordnung (13) zur Messung der Frequenz ($f_0$) des Abstimmoszillators (6) proportional zu den Frequenzfenstern (W1, W2) angepaßt werden.

6. Empfänger (1) nach Anspruch 2, 3, 4, oder 5, dadurch gekennzeichnet, daß der Abstimmteil (12) stromlos wird, wenn die ersten (in-1) und die zweiten (in-w) Steuersignale der Steueranordnung (16) melden, daß die Frequenz ($f_0$) des Abstimmoszillators (6) sich innerhalb des Frequenzfensters (W1), oder bei mehreren Fenstern (W1, W2, W3) innerhalb des inneren Frequenzfensters sowie innerhalb des Fangbereichs der ersten Abstimmregelsignalerzeugungsanordnung (7) befindet.

7. Empfänger (1) nach Anspruch 6, dadurch gekennzeichnet, daß bevor der Abstimmteil (12) stromlos gemacht wird, die zuletzt gemessene Kanalfrequenz ($f_x$) in einem Letzten-Kanal-Speicher (15) gespeichert wird.

8. Empfänger (1) nach Anspruch 2 bis 7, dadurch gekennzeichnet, daß die erste Abstimmregelsignalerzeugungsanordnung (7) von dem Abstimmoszillator (6) entkoppelt wird, wenn die Frequenz ($f_0$) des Abstimmoszillators (6) sich außerhalb des Frequenzfensters (W1), oder bei mehreren Fenstern (W1, W2, W3) außerhalb des inneren Frequenzfensters (W1) befindet und daß danach die zweite Frequenzschleife (L2) aktiv wird.

9. Empfänger (1) nach einem der Ansprüche 1 bis 8, dadurch gekennzeichnet, daß das Frequenzfenster (W1) oder bei mehreren Frequenzfenstern (W1, W2, W3) das inncre Frequenzfenster (W1) kleiner ist als der halbe Kanalabstand innerhalb des Frequenzbandes (B).

10. Empfänger (1) zum Empfangen von HF-SiGnalen mit einem Empfängerteil (2), der eine erste Frequenzschleife (L1) aufweist mit einem Frequenzwandler (3) zur Frequenzumwandlung eines dem Empfängerteil (2) zuführbaren HF-modulierten Signals (RF) zu einem modulierten Signal (IF) mit einer niedrigeren Frequenz, mit einer Detektionsanordnung (5) zur Detektion eines in dem modulierten Signal (IF) mit der niedrigeren Frequenz vorhandenen Informationssignals, und mit einem mit dem Frequenzwandler (3) gekoppelten Abstimmoszillator (6), der in der Frequenz mittels eines ersten Abstimmregelsignals ($I_{afc}$) einstellbar ist, das von einer mit der Detektionsanordnung (5) gekoppelten ersten Abstimmregelsignalerzeugungsanordnung (7) lieferbar ist, wobei der Empfänger (1) einen Abstimmteil (12) aufweist, der eine zweite Frequenzschleife (L2) umfaßt mit einer Frequenzmeßanordnung (13) zum Messen der Frequenz ($f_0$) des Abstimmoszillators (6) und einen zweiten Abstimmregelsignalgenerator (14), der mit der Frequenzmeßanordnung (13) gekoppelt werden kann und der zum Erzeugen eines dem Abstimmoszillator (6) zuzuführenden zweiten Abstimmregelsignals ($I_s$) dient, dadurch gekennzeichnet, daß der Empfänger (1) eine Steueranordnung (16) aufweist, mit der wenigstens in Abhängigkeit eines von dem Empfängerteil (2) lieferbaren Steuersignals (in-1) die erste Frequenzschleife (L1) schließbar ist, in einer Preset-Betriebsart, wobei innerhalb eines Frequenbandes (B) ein beliebiger Kanal ($f_x$) gesucht wird, wobei der Strom zu der Frequenzmeßanordnung (13) unterbrochen wird und die Frequenzmeßanordnung von dem zweiten Abstimmregelsignalgenerator (14) entkoppelt ist, daß der zweite Abstimmregelsignalgenerator (14) unmittelbar den Abstimmoszillator (6) steuert, um das Frequenzband (b) abzutasten, daß die Steueranordnung (16) den Sduchlauf unterbricht auf Basis eines von dem ersten Abstimmregelsignalgenerator (7) zu liefernden Steuersignals (in-1), wenn auf einen Kanal mit einem Signal abgestimmt wird, und daß danach die Frequenzmeßanordnung (13) aktiviert wird zum Messen der Frequenz ($f_0$) des Abstimmoszillators (6) und zur Speicherung der gemessenen Frequenz ($f_x$) in dem Letzten-Kanal-Speicher (15), wonach die Steueranordnung (16) den Abstimmteil stromlos macht.

**Revendications**

1. Récepteur (1) pour recevoir des signaux à haute fréquence, comprenant une partie de réception (2) qui comprend une première boucle de fréquence (L1) dotée d'un dispositif de changement de fréquence (3) pour changer la fréquence d'un signal modulé à haute fréquence (RF), à appliquer à la partie de réception (2), en un signal modulé (IF) de basse fréquence, un dispositif de détection (5) pour détecter un signal d'information présent dans le signal modulé (IF) de basse fréquence, et un oscillateur d'accord (6) qui est couplé au dispositif de changement de fréquence (3) et dont la fréquence peut être réglée au moyen d'un premier signal de commande d'accord ($I_{afc}$) qui peut être fourni par un premier générateur de signaux de commande d'accord (7) couplé au dispositif de détection (5), le récepteur (1) comprenant une partie d'accord (12) qui comprend une deuxième boucle de fréquence (L2) avec un dispositif de mesure de fréquence (13) pour mesurer la fréquence ($f_0$) de l'oscillateur d'accord (6) et un deuxième générateur de signaux de commande d'accord (14) qui peut être couplé au dispositif de mesure de fréquence (13) et qui sert à générer un deuxième signal de commande d'accord ($I_s$) à appliquer à l'oscillateur d'accord (6), caractérisé en ce que le récepteur (1) comprend un dispositif de commande (16) avec lequel la première boucle de fréquence (L1) peut être fermée au moins en fonction d'un premier signal de commande (in-1) devant être fourni par la partie de réception (2), dans un mode de préréglage, dans lequel le dispositif de mesure de fréquence (13) peut être préréglé sur un canal souhaité ($f_x$), le dispositif de mesure de fréquence (13) étant couplé au deuxième générateur de signaux de commande d'accord (14), en ce que la deuxième boucle de fréquence (L2) peut être fermée par le dispositif de commande (16) sur la base d'un deuxième signal de commande (in-w) à appliquer au dispositif de commande (16) par le dispositif de mesure de fréquence (13), en ce que, pour l'accord approximatif, le deuxième signal de commandc d'accord ($I_s$) est en grande partie actif en dehors d'une fenêtre de fréquence (W1) aux alentours du canal souhaité ($f_x$) dans une bande de fréquences (B), en ce que, pour l'accord fin, le premier signal de commande d'accord ($I_{afc}$) est en grande partie actif au moins à l'intérieur de la fenêtre de fréquence (W1), et en ce que le dispositif de commande (16) commande un passage de l'accord approximatif à l'accord fin sur la base des premier (in-1) et deuxième (in-w) signaux de commande.

2. Récepteur (1) suivant la revendication 1, caractérisé en ce que, en mode de préréglage, dans lequel le dispositif de mesure de fréquence (13) peut être préréglé sur canal souhaité ($f_x$), le dispositif de me-

sure de fréquence (13) est couplé au deuxième générateur de signaux de commande d'accord (14), en ce que la deuxième boucle de fréquence (L2) peut être fermée par le dispositif de commande (16) sur la base d'un deuxième signal de commande (in-w) à appliquer au dispositif de commande (16) par le dispositif de mesure de fréquence (13), en ce que, pour l'accord approximatif, le deuxième signal de commande d'accord ($I_s$) est en grande partie actif en dehors d'une fenêtre de fréquence (W1) aux alentours du canal souhaité ($f_x$) dans une bande de fréquences (B), en ce que, pour l'accord fin, le premier signal de commande d'accord ($I_{afc}$) est en grande partie actif au moins à l'intérieur de la fenêtre de fréquence (W1), et en ce que le dispositif de commande (16) commande un passage de l'accord approximatif à l'accord fin sur la base des premier (in-1) et deuxième (in-w) signaux de commande.

3. Récepteur (1) suivant la revendication 2, caractérisé en ce que, pour l'accord approximatif, des fenêtres de fréquence supplémentaires (W2, W3) sont prévues aux alentours du canal souhaité ($f_x$), le premier signal de commande d'accord ($I_{afc}$) étant en grande partie actif au moins à l'intérieur de la fenêtre de fréquence interne (W1), le deuxième signal de commande d'accord ($I_s$) étant plus actif au cours de l'accord approximatif à mesure que la fréquence de l'oscillateur d'accord (6) se situe dans des fenêtres d'accord (W3, W2) plus éloignées de la fréquence souhaitée ($f_x$).

4. Récepteur (1) suivant la revendication 3, caractérisé en ce que, par rapport à la fenêtre de fréquence interne (W1), les fenêtres de fréquence supplémentaires (W2, W3) constituent une distribution géométrique sur la bande de fréquences (B), le deuxième signal de commande d'accord ($I_s$) étant un courant dont le rapport de valeurs sur les fenêtres de fréquence (W1, W2, W3) est identique à celui des facteurs de pondération quant à la distribution géométrique.

5. Récepteur (1) suivant la revendication 3 ou 4, caractérisé en ce que les périodes de mesure de fréquence ($\tau_{m1}$, $\tau_{m2}$) du dispositif de mesure de fréquence (13) pour mesurer la fréquence ($f_0$) de l'oscillateur d'accord (6) sont adaptées proportionnellement aux fenêtres de fréquence (W1, W2).

6. Récepteur (1) suivant la revendication 2, 3, 4 ou 5, caractérisé en ce que l'alimentation vers la partie d'accord (12) est interrompue lorsque les premier (in-1) et deuxième (in-w) signaux de commande informent le dispositif de commande (16) que la fréquence ($f_0$) de l'oscillateur d'accord (6) se situe à l'intérieur de la fenêtre de fréquence (W1), ou à l'intérieur de la fenêtre de fréquence interne (W1) dans le cas d'une pluralité de fenêtres (W1, W2, W3), ainsi qu'à l'intérieur de la plage de synchronisation du premier générateur de signaux de commande d'accord (7).

7. Récepteur (1) suivant la revendication 6, caractérisé en ce que, avant que l'alimentation vers la partie d'accord (12) soit interrompue, la fréquence de dernier canal mesurée ($f_x$) est stockée dans une mémoire de dernier canal (15).

8. Récepteur (1) suivant l'une quelconque des revendications 2 à 7, caractérisé en ce que le premier générateur de signaux de commande d'accord (7) est découplé de l'oscillateur d'accord (6) lorsque la fréquence ($f_0$) de l'oscillateur d'accord (6) est en dehors de la fenêtre de fréquence (W1), ou en dehors de la fenêtre de fréquence interne (W1) dans le cas d'une pluralité de fenêtres (W1, W2, W3), la deuxième boucle de fréquence (L2) étant par la suite activée.

9. Récepteur suivant l'une quelconque des revendications 2 à 8, caractérisé en ce que la fenêtre de fréquence (W1), ou la fenêtre de fréquence interne (W1) dans le cas d'une pluralité de fenêtres de fréquence (W1, W2, W3), est plus étroite que la moitié de l'écartement de canal à l'intérieur de la bande de fréquences (B).

10. Récepteur (1) pour recevoir des signaux à haute fréquence, comprenant une partie de réception (2) qui comprend une première boucle de fréquence (L1) dotée d'un dispositif de changement de fréquence (3) pour changer la fréquence d'un signal modulé à haute fréquence (RF), à appliquer à la partie de réception (2), en un signal modulé (IF) de basse fréquence, un dispositif de détection (5) pour détecter un signal d'information présent dans le signal modulé (IF) de basse fréquence, et un oscillateur d'accord (6) qui est couplé au dispositif de changement de fréquence (3) et dont la fréquence peut être réglée au moyen d'un premier signal de commande d'accord ($I_{afc}$) qui peut être fourni par un premier générateur de signaux de commande d'accord (7) couplé au dispositif de détection (5), le récepteur (1) comprenant une partie d'accord (12) qui comprend une deuxième boucle de fréquence (L2) avec un dispositif de mesure de fréquence (13) pour mesurer la fréquence ($f_0$) de l'oscillateur d'accord (6) et un deuxième générateur de signaux de commande d'accord (14) qui peut être couplé au dispositif de mesure de fréquence (13) et qui sert à générer un deuxième signal de commande d'accord ($I_s$) à appliquer à l'oscillateur d'accord (6), caractérisé en ce que le récepteur (1) comprend un dispositif de commande (16) avec lequel la première boucle de fréquence (L1) peut être fermée au moins en fonction d'un premier signal de commande (in-1) devant être fourni par la partie de réception (2), dans un mode de recherche, dans lequel un canal arbitraire ($f_x$) est recherché à l'intérieur d'une bande de fréquences (B), l'alimentation vers le dispositif de mesure de fréquence (13) étant interrompue et le dispositif de mesure de fréquence étant découplé du deuxième générateur de signaux de commande d'accord (14), en ce que le deuxième générateur de signaux de commande d'accord (14) commande directement l'oscillateur d'accord (6) de manière à balayer la bande de fréquences (B), en ce que le dispositif de commande (16) interrompt le mode de recherche, sur la base d'un signal de commande (in-1) devant être fourni par le premier générateur de signaux de commande d'accord (7), lorsqu'un accord est effectué sur un canal contenant un signal, et en ce qu'ensuite le dispositif de mesure de fréquence (13) est activé de manière à mesurer la fréquence ($f_0$) de l'oscillateur d'accord (6) et à stocker la fréquence mesurée ($f_x$) dans une mémoire de dernier canal (15), après que le dispositif de commande (16) interrompt l'alimentation vers la partie d'accord.

FIG.1

FIG.2

FIG.3

FIG.4

FIG.5

FIG.6

FIG.7